# EUROPÄISCHE PATENTSCHRIFT

(11) **EP 3 351 951 B1**
(45) Veröffentlichungstag und Bekanntmachung des Hinweises auf die Patenterteilung: **03.07.2019**
(21) Anmeldenummer: 18158533.2
(22) Anmeldetag: 31.01.2017
(51) Int. Cl.: G01R 31/02, H02H 3/16, H02H 3/33, H02H 5/10

(54) **VERFAHREN UND VORRICHTUNGEN ZUR ERKENNUNG EINER UNTERBRECHUNG EINER SCHUTZLEITERVERBINDUNG MITTELS EINES ABLEITSTROMSPEKTRUMS**
METHOD AND DEVICES FOR DETECTING AN INTERRUPTION OF A PROTECTIVE EARTH CONNECTION BY MEANS OF A LEAKAGE CURRENT SPECTRUM
PROCÉDÉ ET DISPOSITIF DE DÉTECTION D'UNE RUPTURE D'UNE CONNEXION DE FILS DE PROTECTION AU MOYEN D'UN SPECTRE DE COURANT DE FUITE

(30) Priorität: 10.02.2016 DE 102016202021
(43) Veröffentlichungstag der Anmeldung: 25.07.2018
(62) Teilanmeldung aus: 17153856.4
(73) Patentinhaber: Bender GmbH & Co. KG, 35305 Grünberg (DE)
(72) Erfinder: HACKL, Dieter, 35463 Fernwald (DE); SELLNER, Harald, 35305 Grünberg (DE)
(74) Vertreter: advotec.

(56) Entgegenhaltungen:
- EP-A1- 2 006 694
- EP-A1- 2 568 557
- EP-A1- 2 568 560
- EP-A2- 2 574 939
- WO-A1-03/100938
- DE-A1- 19 826 410
- DE-U1- 20 220 276

## Beschreibung

Die Erfindung betrifft ein Verfahren und eine elektrische Schutzvorrichtung zur Erkennung einer Unterbrechung einer Schutzleiterverbindung zu einem Subsystem eines geerdeten Stromversorgungssystems, wobei an das Subsystem ein Umrichtersystem angeschlossen ist.

In einem Stromversorgungssystem ist eine Schutzerdung von leitfähigen berührbaren Teilen eines elektrischen Betriebsmittels als Schutzvorkehrung ein wichtiger Bestandteil der normativ geforderten Schutzmaßnahme "Schutz durch automatische Abschaltung der Stromversorgung". Dies gilt unabhängig davon, ob es sich um die Netzform eines ungeerdeten Stromversorgungsystems (frz. Isolé Terre - IT-Netz) oder eines geerdeten Stromversorgungssystems (frz. Terre Neutre - TN-Netz oder frz. Terre Terre - TT-Netz) handelt.

Die Schutzerdung eines Subsystems eines verzweigten Stromversorgungssystems durch eine Schutzleiterverbindung zu dem Subsystem verdient daher besondere Beachtung, da dieser Schutz in den meisten Fällen durch eine Unterbrechung des Schutzleiters unwirksam wird.

Unter Subsystem sei hier eine abschaltbare Einheit eines Gesamt-Stromversorgungssystems verstanden. Dieses Subsystem umfasst in der Regel ein oder mehrere elektrische Betriebsmittel.

Kommt zu der Unterbrechung einer Schutzleiterverbindung (erster Fehler) ein weiterer (zweiter) Fehler hinzu, wie beispielsweise das Versagen der Basisisolierung durch Überbrücken von Luft- und Kriechstrecken oder aufgrund einer schadhaften Isolierung, besteht ein erhöhtes Risiko für einen elektrischen Schlag.

Da das Auftreten dieser Zweifehlersituation in Stromversorgungsystemen nicht vernachlässigbar gering ist, hat sich in geerdeten Stromversorgungssystemen als zusätzlicher Schutz der Einsatz von Fehlerstrom-Schutzeinrichtungen (RCDs) durchgesetzt.

In vielen industriellen Stromversorgungsystemen ist der Einsatz von RCDs als zusätzlicher Schutz gegen elektrischen Schlag jedoch nicht möglich, da beispielsweise durch in dem Stromversorgungssystem vorhandene sehr große Netzableitkapazitäten auch ohne einen zusätzlichen Fehlerstrom bereits ein Ableitstrom fließt, der deutlich über 30 mA liegen kann und somit in dem Stromversorgungssystem vorhandene RCDs sofort zum Auslösen bringen würde.

Kann in einem geerdeten Stromversorgungssystem das RCD aufgrund zu hoher Ableitströme nicht eingesetzt werden oder ist das eingesetzte RCD nicht für den Schutz gegen elektrischen Schlag geeignet (nur für den Brand- und Anlagenschutz ausgelegt), so besteht bei einer unterbrochenen Schutzleiterverbindung und einem zweiten Fehler die Gefahr, dass eine Person bei bestimmungsgemäßer Bedienung des Betriebsmittels einen gefährlichen Elektrounfall erleidet, da sich der Fehlerstromkreis über den Körper der Person schließt.

Bei intakter Schutzleiterverbindung hingegen fließt der Fehlerstrom bei Versagen der Basisisolierung fast ausschließlich über den Schutzleiter zurück zum Einspeisepunkt des geerdeten Stromversorgungssystems. Allerdings führt dies - bei richtiger Auslegung des geerdeten Stromversorgungssystems - zu sehr hohen Erdschlussströmen und meistens auch zu Berührungsspannungen mit gefährlich hoher Amplitude. Aus diesem Grund muss ein geerdetes Stromversorgungssystem bei einem ersten Fehler schnell genug abgeschaltet werden.

Besonderes Augenmerk im Hinblick auf Schutzvorkehrungen verdient die Installation von Umrichtersystemen in geerdeten Stromversorgungssystemen. Die Schutzleiterverbindung zu einem Umrichtersystem ist besonders kritisch, da Isolationsfehler am Ausgang des Umrichtersystems gegen berührbare und leitfähige Teile eines umrichtergesteuerten Antriebs zu Fehlerströmen führen können, die neben netzfrequenten Anteilen auch ein recht breitbandiges Spektrum an umrichterspezifischen Spektralanteilen von Gleichstrom-Komponenten bis hin zu Anteilen im MHz-Bereich aufweisen können.

Auch ist zu beachten, dass große Ableitkapazitäten zwischen den Ausgangsphasen des Umrichters und dem Antriebsgehäuse (Ausgangsfilter) für die höherfrequenten Anteile eine niederimpedante Verbindung darstellen können.

Herkömmliche RCDs vom Typ A liefern hier keinen zuverlässigen zusätzlichen Schutz. Eine Berührung des umrichtergesteuerten Antriebs kann bei einer fehlerhaften Schutzleiterverbindung zu einem elektrischen Schlag führen, ohne dass ein RCD Typ A dies erkennt. Selbst der Einsatz mischfrequenzsensitiver RCDs vom Typ F hilft meist nicht zuverlässig gegen die Gefährdung durch elektrischen Schlag.

Betriebsmäßig liegen die Ableitströme im Schaltfrequenzbereich des Umrichters (kHz-Bereich) meistens schon deutlich über 30 mA, häufig wird in leistungsstarken Umrichterantrieben sogar betriebsmäßig die Ableitstromgrenze von 300 mA überschritten. Der Einsatz eines RCDs ist in solchen Systemen selbst aus Brandschutzgründen nicht möglich.

Eine der wichtigsten Schutzvorkehrungen ist vor allem in leistungsstarken Umrichterantrieben somit eine zuverlässige Schutzerdung der berührbaren leitfähigen Antriebsteile.

Auch in einem ungeerdeten Stromversorgungssystem, bei dem definitionsgemäß alle aktiven Teile des Stromversorgungssystems von dem Erdpotenzial - gegenüber Erde - getrennt und die angeschlossenen Betriebsmittel durch einen Schutzleiter mit einer Erdungsanlage verbunden sind, kann eine Zweifehlersituation bei Berührung eines Betriebsmittels gefährlich werden, wenn es sich um ein weit ausgedehntes ungeerdetes Stromversorgungssystem mit einer demzufolge großen Gesamtnetzableitkapazität handelt. Der Fehlerstromkreis wird in dieser Zweifehlersituation über die berührende Person und die Netzableitkapazitäten geschlossen.

Bei intakter Schutzleiterverbindung fließt der Fehlerstrom bei fehlerhafter Basisisolierung nahezu vollständig über den Schutzleiter und die Netzableitkapazitäten. Dies führt auch im einfachen Fehlerfall in einem ungeerdeten Stromversorgungssystem nur zu ungefährlichen Berührungsspannungen an dem Betriebsmittel. Aus diesem Grund kann ein ungeerdetes Stromversorgungssystem bei einem ersten Fehler weiterbetrieben werden.

Um der durch einen unterbrochenen Schutzleiter entstehenden Gefährdung zu begegnen, sind aus dem Stand der Technik Lösungen bekannt, die jedoch teils erhebliche Nachteile aufweisen.

Aus der Offenlegungsschrift WO 03/100938 A1 ist ein Fehlerstrom-Schutzschalter mit einer auf spektraler Charakterisierung beruhender Signalanalyse des Fehlerstroms bekannt. Insbesondere bei nicht rein sinusförmigen Fehlerströmen soll damit ein vorhersagbares Auslöseverhalten erreicht werden. Leistungsarbeitspunkte eines Umrichtersystems werden dabei nicht berücksichtigt.

Die Offenlegungsschrift EP 2568557 A1 zeigt ein Verfahren zur Detektion von Fehlerströmen für einen Fehlerstrom-Schutzschalter bei Umrichterbetrieb. Dabei werden zur zuverlässigeren Auswertung des Frequenzspektrums des Ableitstroms Schaltinformationen über Schaltvorgänge des Frequenzumrichters an den Fehlerstrom-Schutzschalter benötigt.

Die Offenlegungsschrift EP 2568560 A1 beschreibt ein Verfahren zum Erkennen und gegebenenfalls Blockieren eines Fehlerstroms in einem Frequenzumrichter, wobei der zeitliche Verlauf oder ein spektrales Band eines über den Frequenzumrichter fließenden Stroms ausgewertet wird.

Weitere Vorschläge existieren für eine selektive Fehlerstromerfassung, welche zwischen Ableitströmen und Fehlerströmen unterscheiden kann. RCDs auf Basis dieser Ideen sind jedoch nicht verfügbar, da die zuverlässige Funktion im 3-Phasen-Wechselstrom-System bislang nicht nachgewiesen werden konnte.

Weiterhin sind Geräte auf dem Markt verfügbar, die den Einsatz von Fehlerstrom-Schutzeinrichtungen zum Schutz gegen elektrischen Schlag auch in industriellen Systemen ermöglichen sollen, indem kapazitive Ableitströme kompensiert werden. Allerdings ist nicht bekannt, wie zuverlässig derartige Schutzeinrichtungen in weitverzweigten Industrienetzen mit wechselnden, komplexen Betriebszuständen arbeiten.

Schließlich existieren Schleifenüberwachungsgeräte auf dem Markt, die eine Schutzleiteranschlussüberwachung direkt an den Betriebsmitteln vornehmen. Bei einer Vielzahl von Betriebsmitteln an verschiedenen Netzzweigen werden entsprechend viele Schleifenüberwachungsgeräte benötigt.

Der vorliegenden Erfindung liegt somit die Aufgabe zu Grunde, ein Verfahren und eine elektrische Schutzeinrichtung anzugeben, die in geerdeten verzweigten, d.h. mit abschaltbaren Einheiten (Subsystemen) versehenen, Stromversorgungssystemen eine Unterbrechung einer Schutzleiterverbindung zu einem Subsystem im Vorfeld erkennen, ohne dass es zu einer Betriebsunterbrechung kommt. Besondere Bedeutung soll dabei in einem geerdeten Stromversorgungssystem dem Sonderfall eines an das Subsystem angeschlossenen Umrichtersystems zukommen.

Für ein geerdetes Stromversorgungssystem, an dessen Subsystem ein Umrichtersystem angeschlossen ist, wird die Aufgabe gelöst durch ein erfindungsgemäßes Verfahren nach Anspruch 1.

Ausgangspunkt ist in dieser Konstellation eine Messung eines für das Umrichtersystem spezifischen Ableitstroms in einem fehlerfreien Zustand des geerdeten Stromversorgungssystems. Diese Messung wird für alle relevanten, betriebsmäßig zu erwartenden Leistungsarbeitspunkte des Umrichtersystems vorgenommen.

Eine Transformation des zeitlichen Verlaufs des jeweiligen Ableitstroms in den Spektralbereich dient als für dieses Umrichtersystem spezifisches Referenz-Ableitstromspektrum und zeigt eine für einen bestimmten Leistungsarbeitspunkt des Umrichters charakteristische Ausprägung bei intakter Schutzleiterverbindung.

Eine Unterbrechung der Schutzleiterverbindung zu dem an das Subsystem angeschlossenen Umrichtersystem bewirkt einen Wegfall der Teilnetzableitkapazität des Subsystems und infolgedessen eine detektierbare Änderung in den Ableitstromspektren.

Während des Betriebs des Stromversorgungssystems mit dem über das Subsystem angeschlossenen Umrichtersystem wird kontinuierlich der aktuelle Ableitstrom gemessen und daraus ein dem augenblicklichen Leistungsarbeitspunkt des Umrichters entsprechendes aktuelles Ableitstromspektrum berechnet. Dieses Ableitstromspektrum wird mit dem korrespondierenden Referenz-Ableitstromspektrum verglichen, wobei eine Abweichung zwischen dem aktuell berechneten Ableitstromspektrum und dem korrespondierenden Referenz-Ableitstromspektrum auf eine Unterbrechung der Schutzleiterverbindung schließen lässt.

In weiterer Ausgestaltung umfasst das Berechnen des Umrichtersystem-spezifischen Referenz-Ableitstromspektrums und das Berechnen des aktuellen Ableitstromspektrums während des Betriebs des Umrichtersystems eine Berechnung von signifikanten Ableitstrom-Spektralkomponenten, wobei die signifikanten Ableitstrom-Spektralkomponenten während der Inbetriebnahme des Umrichtersystems in einer Lernphase den Leistungsarbeitspunkten zugeordnet werden.

Im Hinblick auf eine Reduzierung des Rechenaufwands bei der Berechnung der Ableitstromspektren genügt die Berechnung bestimmter signifikanter Spektralkomponenten innerhalb des gesamten Ableitstromspektrums. Die Signifikanz der ausgewählten Ableitstrom-Spektralkomponenten ergibt sich dadurch, dass an diesen Frequenzstellen eine deutliche (Amplituden-)Änderung infolge des Wegfalls der Teilnetzableitkapazität des Subsystems erkennbar wird.

In einer Lernphase während der Inbetriebnahme des Umrichtersystems erfolgt die Zuordnung der signifikanten Ableitstrom-Spektralkomponenten zu den Leistungsarbeitspunkten.

In vorteilhafter Weise wird das Prüfen der aktuell berechneten Ableitstromspektren jeweils durch einen Vergleich an Stellen der signifikanten Ableitstrom-Spektralkomponenten durchgeführt.

Zur Prüfung, ob das aktuell berechnete Ableitstromspektrum eine Abweichung von dem entsprechenden Referenz-Ableitstromspektrum aufweist, ist es somit nicht erforderlich, das gesamte Ableitstromspektrum zu berechnen, sondern die Prüfung erfolgt mit geringem Rechenaufwand auf Basis der ausgewählten signifikanten Ableitstrom-Spektralkomponenten.

Mit Vorteil erfolgt das Ermitteln der Referenzwerte Referenz-Gesamtnetzableitkapazität, Referenz-Gesamtdifferenzstrom, Referenz-Ableitstromspektrum bei einer Erstinbetriebnahme und unmittelbar nach einer Wiederholungsprüfung des Stromversorgungssystems.

Bei einer Erstinbetriebnahme und unmittelbar nach einer Wiederholungsprüfung kann davon ausgegangen werden, dass sich das Stromversorgungssystem, insbesondere die Schutzleiterverbindungen, in fehlerfreiem Zustand befindet/befinden, sodass in dieser Phase zuverlässige Referenzwerte ermittelt werden können.

Alternativ oder ergänzend zu der Ermittlung der Referenzwerte im Rahmen der Erstinbetriebnahme und der Wiederholungsprüfung erfolgt das Ermitteln der Referenzwerte Referenz-Gesamtnetzableitkapazität, Referenz-Gesamtdifferenzstrom, Referenz-Ableitstromspektrum durch eine Filterung der gemessenen Werte.

Mittels einer Filterung, beispielsweise durch eine gleitende Mittelwertbildung, wird eine kontinuierliche, träge Anpassung des Referenzwertes an sich ändernde Systembedingungen erreicht. Sprunghafte Änderungen des aktuellen Messwertes gegenüber dem so ermittelten trägen Referenzwert werden als fehlerhafte Ereignisse (Schutzleiter-Abriss) erkannt.

In Umsetzung des erfindungsgemäßen Verfahrens nach Anspruch 1 wird die Aufgabe für ein geerdetes Stromversorgungssystems mit einem an ein Subsystem angeschlossenen Umrichtersystem gelöst durch eine erfindungsgemäße elektrische Schutzvorrichtung nach Anspruch 6.

Die elektrische Schutzvorrichtung weist hierzu eine Vorrichtung zur Messung eines Ableitstroms, eine Recheneinheit zur Berechnung eines Ableitstromspektrums sowie eine Auswertungs-Prozesseinheit zur Prüfung der berechneten Ableitstromspektren und zur Signalisierung der Unterbrechung der Schutzleiterverbindung auf.

Die Vorrichtung zur Messung eines Ableitstroms erfasst einen für das Umrichtersystem spezifischen Ableitstrom für verschiedene Leistungsarbeitspunkte des Umrichtersystems. Die Erfassung erfolgt als Referenz-Ableitstrom in einem fehlerfreien Zustand des geerdeten Stromversorgungssystems und als aktueller Ableitstrom während des Betriebs des Umrichtersystems.

In der Recheneinheit erfolgt eine Transformation des zeitlichen Verlaufs des Ableitstroms in ein Ableitstromspektrum, auf dessen Grundlage die Auswertungs-Prozesseinheit prüft, ob eine Abweichung des aktuell berechneten Ableitstromspektrums von dem entsprechenden Referenz-Ableitstromspektrum vorliegt.

Weiter bilden die Vorrichtung zur Messung des Ableitstroms, die Recheneinheit zur Berechnung des Ableitstromspektrums und die Auswertungs-Prozesseinheit ein integriertes Kombigerät auf der Basis eines Gerätes zur Bestimmung der Netzqualität als bauliche Einheit aus.

Ein integriertes Kombigerät bietet die bereits oben genannten Vorteile einer vereinfachten Inbetriebnahme und erhöhten Zuverlässigkeit der elektrischen Schutzvorrichtung und vermindert den schaltungstechnischen Aufwand. Bevorzugt bietet ein vorhandenes Gerät zur Bestimmung der Netzqualität (PQ-Gerät) die Basis für das integrierte Kombigerät.

Mit dem erfindungsgemäßen Verfahren und dessen Umsetzung mittels der korrespondierenden elektrischen Schutzvorrichtung wird eine wirksame Überwachung der Schutzleiterverbindung möglich. Insbesondere kann eine Unterbrechung einer Schutzleiterverbindung zu einem Subsystem im Vorfeld erkannt werden, sodass es zu keiner zeitaufwändigen und kostenverursachenden Betriebsunterbrechung kommt.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: eine Darstellung einer Schutzerdung in einem ungeerdeten Stromversorgungssystem mit einer elektrischen Schutzvorrichtung und
- **Fig. 2:**: eine Darstellung einer Schutzerdung in einem geerdeten Stromversorgungssystem mit einer erfindungsgemäßen elektrischen Schutzvorrichtung.

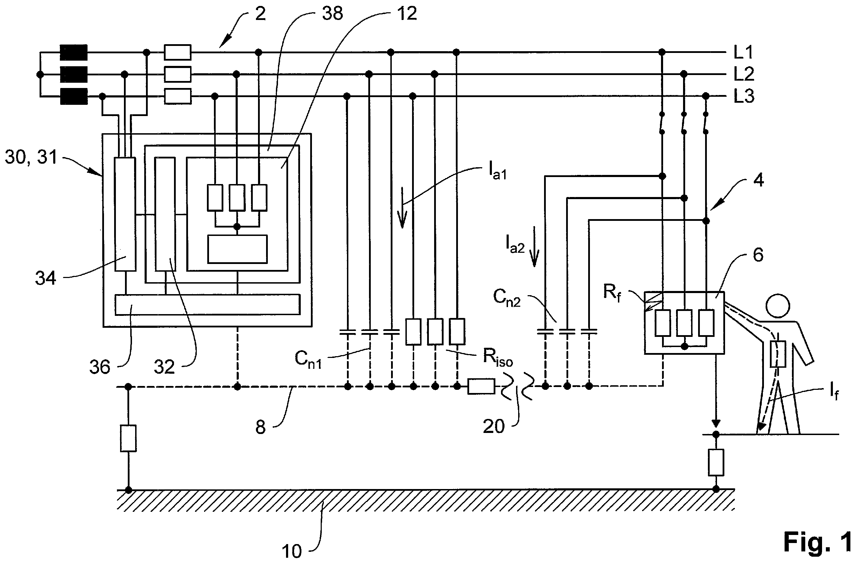

**Fig. 1** zeigt eine Schutzerdung in einem ungeerdeten (IT) Dreiphasen-(Wechsel-)Stromversorgungssystem 2 mit den aktiven Leitern L1, L2, L3. Das Stromversorgungsystem 2 umfasst ein abschaltbares Subsystem 4 mit einem Betriebsmittel 6, das über eine zu dem Subsystem 4 führende Schutzleiterverbindung 8 mit einer Erdungsanlage verbunden ist. Alle aktiven Teile des ungeerdeten Stromversorgungssystems 2 sind definitionsgemäß gegenüber Erde 10 getrennt. Das Stromversorgungssystem 2 ist weiterhin gekennzeichnet durch die Netzableitkapazitäten Cnl eines Hauptsystems und die Netzableitkapazitäten Cn2 des Subsystems 4, wobei die Summe der Netzableitkapazitäten Cnl und Cn2 aufgrund ihrer Parallelschaltung eine Gesamtnetzableitkapazität des ungeerdeten Stromversorgungssystems 2 ergibt. Über die Netzableitkapazitäten Cnl und Cn2 fließen (in fehlerfreiem Zustand und bei eingeschaltetem Subsystem 4) jeweils die Ableitströme Ia1 und Ia2, die im vorliegenden Fall des Wechselstromsystems proportional zu den jeweiligen Netzableitkapazitäten Cnl und Cn2 sind.

Ein zwischen den aktiven Leitern L1, L2, L3 und Erde 10 angeschlossenes Isolationsüberwachungsgerät 12 überwacht ein Isolationswiderstand Riso des Stromversorgungsystems 2 (in vereinfachter Darstellung ist vorliegend nur der Isolationswiderstand Riso des Hauptsystems eingezeichnet, erfasst werden aber auch parallel geschaltete, nicht dargestellte Isolationswiderstände vorhandener Subsysteme).

In dem dargestellten Betriebsfall ist eine Unterbrechung 20 (erster Fehler) der Schutzleiterverbindung 8 zu dem Subsystem 4 aufgetreten. Kommt nun ein zweiter Fehler Rf bei dem an das Subsystem 4 angeschlossenen Betriebsmittel 6 hinzu (Zweifehlersituation), beispielsweise aufgrund einer schadhaften Isolierung, so fließt ein Fehlerstrom If über die berührende Person und die Netzableitkapazitäten Cn1. Insbesondere in weitläufigen Stromversorgungssystemen 2 mit großen Netzableitkapazitäten Cnl kann der Fehlerstrom If gefährlich hohe Werte annehmen.

Eine elektrische Schutzvorrichtung 30 zur Erkennung der Unterbrechung 20 der Schutzleiterverbindung 8 weist Messvorrichtungen 32, 34 und eine Auswertungs-Prozesseinheit 36 auf. Im Einzelnen sind dies eine Vorrichtung 32 zur Messung der Gesamtnetzableitkapazität des ungeerdeten Stromversorgungssystems 2, eine Vorrichtung 34 zur Messung der über das ungeerdete Stromversorgungssystem 2 aufgenommenen Gesamtleistung sowie eine Auswertungs-Prozesseinheit 36 zur Prüfung der gemessenen Gesamtnetzableitkapazität und der gemessenen aufgenommenen Gesamtleistung und zur Signalisierung der Unterbrechung 20 der Schutzleiterverbindung 8.

Die Vorrichtung 32 bildet zur Messung der Gesamtnetzableitkapazität zusammen mit dem Isolationsüberwachungsgerät 12 ein erweitertes Isolationsüberwachungsgerät 38, welches wiederum zusammen mit der Vorrichtung 34 zur Messung der Gesamtleistung und der Auswertungs-Prozesseinheit 36 ein integriertes Kombigerät 31 als bauliche Einheit ausbildet.

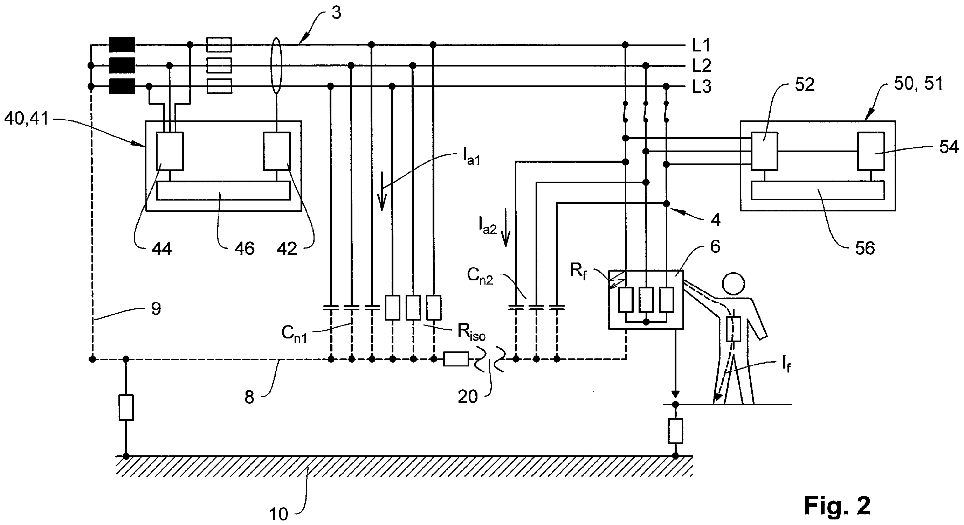

In **Fig. 2** ist der gleiche Betriebsfall (Zweifehlersituation) wie für das ungeerdete Stromversorgungssystem 2 aus Fig. 1 für ein geerdetes (TN) Dreiphasen-(Wechsel-)Stromversorgungssystem 3 mit den aktiven Leitern L1, L2, L3 gezeigt. Im Gegensatz zu dem ungeerdeten Stromversorgungssystem 2 (Fig. 1) weist das geerdete Stromversorgungssystem 3 an seinem Einspeisepunkt eine direkte Erdverbindung 9 auf. Aufgrund der Unterbrechung 20 der Schutzleiterverbindung 8 fließt der Fehlerstrom If vollständig über die berührende Person.

Durch eine Messung des Gesamtdifferenzstroms und der Gesamtleistung des geerdeten Stromversorgungssystems 3 wird in Verbindung mit einer Auswertung der Messergebnisse eine Unterbrechung 20 der Schutzleiterverbindung 8 erkannt.

Dazu weist die elektrische Schutzvorrichtung 40 eine Vorrichtung 42 zur Messung eines Gesamtdifferenzstroms des geerdeten Stromversorgungssystems 3, eine Vorrichtung 44 zur Messung einer über das geerdete Stromversorgungssystem aufgenommenen Gesamtleistung sowie eine Auswertungs-Prozesseinheit 46 zur Prüfung des gemessenen Gesamtdifferenzstroms und der gemessenen aufgenommenen Gesamtleistung und zur Signalisierung der Unterbrechung 20 der Schutzleiterverbindung 8 auf.

Die Vorrichtung 42 zur Messung des Gesamtdifferenzstroms, die Vorrichtung 44 zur Messung der aufgenommenen Gesamtleistung und die Auswertungs-Prozesseinheit 46 bilden ein integriertes Kombigerät 41 auf der Basis eines Gerätes zur Bestimmung der Netzqualität als bauliche Einheit aus.

Im Fall eines an das Subsystem angeschlossenen Umrichtersystems - in Fig. 2 kann das Betriebsmittel 6 als ein solches Umrichtersystem aufgefasst werden - ist in der Zuleitung des Subsystems 4 eine elektrische Schutzvorrichtung 50 zur Erkennung einer Unterbrechung einer Schutzleiterverbindung bei Umrichterbetrieb angeordnet.

Die erfindungsgemäße elektrische Schutzvorrichtung 50 für Subsysteme 4 mit Umrichtersystem umfasst eine Vorrichtung 52 zur Messung eines Ableitstroms, eine Recheneinheit 54 zur Berechnung eines Ableitstromspektrums sowie eine Auswertungs-Prozesseinheit 56 zur Prüfung der berechneten Ableitstromspektren und zur Signalisierung der Unterbrechung 20 der Schutzleiterverbindung 8. Dabei kann die Implementierung der elektrischen Schutzvorrichtung 50 in Form eines integrierten Kombigerätes 51 auf der Basis eines Gerätes zur Bestimmung der Netzqualität als bauliche Einheit erfolgen.

Sofern nicht Schutzleiterverbindungen zu weiteren Subsystemen zu überwachen sind, kann die nicht für Umrichterbetrieb vorgesehene elektrische Schutzvorrichtung 40 entfallen.

## Patentansprüche

1. Verfahren zur Erkennung einer Unterbrechung (20) einer Schutzleiterverbindung (8) zu einem Subsystem (4) eines geerdeten Stromversorgungssystems (3), mit einem an das Subsystem (4) angeschlossenen Umrichtersystem, umfassend die während einer Inbetriebnahme des Umrichtersystems durchzuführenden Verfahrensschritte:
- Messen jeweils eines für das Umrichtersystem spezifischen Ableitstroms für verschiedene Leistungsarbeitspunkte des Umrichtersystems in einem fehlerfreien Zustand des geerdeten Stromversorgungssystems (3),
- Berechnen eines für das Umrichtersystem spezifischen Referenz-Ableitstromspektrums des jeweiligen Ableitstroms,
und umfassend die wiederholt während des Betriebs des Umrichtersystems durchzuführenden Verfahrensschritte:
- Messen jeweils eines aktuellen Ableitstroms für die verschiedenen Leistungsarbeitspunkte des Umrichtersystems,
- Berechnen eines aktuellen Ableitstromspektrums des jeweiligen aktuellen Ableitstroms,
- Prüfen, ob das aktuell berechnete Ableitstromspektrum eine Abweichung von dem entsprechenden Referenz-Ableitstromspektrum aufweist,
- Signalisieren, dass eine Unterbrechung (20) der Schutzleiterverbindung (8) vorliegt, falls die Prüfung ergibt, dass die Abweichung des aktuell berechneten Ableitstromspektrums von dem entsprechenden Referenz-Ableitstromspektrum vorliegt.

2. Verfahren nach Anspruch 1,
**dadurch gekennzeichnet,**
**dass** das Berechnen des Umrichtersystem-spezifischen Referenz-Ableitstromspektrums und das Berechnen des aktuellen Ableitstromspektrums während des Betriebs des Umrichtersystems eine Berechnung von signifikanten Ableitstrom-Spektralkomponenten umfasst, wobei die signifikanten Ableitstrom-Spektralkomponenten während der Inbetriebnahme des Umrichtersystems in einer Lernphase den Leistungsarbeitspunkten zugeordnet werden.

3. Verfahren nach Anspruch 2,
**dadurch gekennzeichnet,**
**dass** das Prüfen der aktuell berechneten Ableitstromspektren jeweils durch einen Vergleich an Stellen der signifikanten Ableitstrom-Spektralkomponenten durchgeführt wird.

4. Verfahren nach einem der Ansprüche 1 bis 3,
**dadurch gekennzeichnet,**
**dass** das Ermitteln des Referenz-Ableitstromspektrums bei einer Erstinbetriebnahme und unmittelbar nach einer Wiederholungsprüfung des Stromversorgungssystems (2, 3) erfolgt.

5. Verfahren nach einem der Ansprüche 1 bis 4,
**dadurch gekennzeichnet,**
**dass** das Ermitteln des Referenz-Ableitstromspektrums durch eine Filterung der gemessenen Werte erfolgt.

6. Elektrische Schutzvorrichtung (50) zur Erkennung einer Unterbrechung (20) einer Schutzleiterverbindung (8) zu einem Subsystem (4) eines geerdeten Stromversorgungssystems (3), mit einem an das Subsystem (4) angeschlossenen Umrichtersystem, die elektrische Schutzvorrichtung umfassend eine Vorrichtung (52) zur Messung eines Ableitstroms, eine Recheneinheit (54) zur Berechnung eines Ableitstromspektrums sowie eine Auswertungs-Prozesseinheit (56) zur Prüfung der berechneten Ableitstromspektren und zur Signalisierung der Unterbrechung (20) der Schutzleiterverbindung (8),
**dadurch gekennzeichnet, dass**
die Auswertungs-Prozesseinheit (56) so konfiguriert ist, dass sie die Schritte des Verfahrens nach Anspruch 1 ausführt.

7. Elektrische Schutzvorrichtung (50) nach Anspruch 6,
**dadurch gekennzeichnet,**
**dass** die Vorrichtung (52) zur Messung des Ableitstroms, die Recheneinheit (54) zur Berechnung des Ableitstromspektrums und die Auswertungs-Prozesseinheit (56) ein integriertes Kombigerät (51) auf der Basis eines Gerätes zur Bestimmung der Netzqualität als bauliche Einheit ausbilden.

## Claims

1. A method for detecting a disconnection (20) of a protective conductor connection (8) with a subsystem (4) of a grounded power supply system (3), comprising a converter system connected to the subsystem (4), comprising the method steps to be executed during activation of the converter system:
- measuring a leakage current specific to the converter system for each one of different power operating points of the converter system in a fault-free state of the grounded power supply system (3),
- calculating a reference leakage current spectrum of the respective leakage current specific to the converter system,
and comprising the method steps to be repeatedly executed during operation of the converter system:
- measuring a current leakage current for each of the different power operating points of the converter system,
- calculating a current leakage-current spectrum of the respective current leakage current,
- testing whether the currently calculated leakage current spectrum deviates from the corresponding reference leakage current spectrum,
- signaling that there is a disconnection (20) of the protective conductor connection (8) if the test reveals that the currently calculated leakage current spectrum deviates from the corresponding reference leakage current spectrum.

2. The method according to claim 1,
**characterized in that**
calculating the reference leakage current spectrum specific to the converter system and calculating the current leakage current spectrum during operation of the converter system comprises calculating significant leakage-current spectral components, the significant leakage-current spectral components being assigned to the power operating points in a learning phase during activation of the converter system.

3. The method according to claim 2,
**characterized in that**
the currently calculated leakage current spectra are each tested by a comparison at points of the significant leakage-current spectral components.

4. The method according to any one of claims 1 to 3,
**characterized in that**
the reference leakage current spectrum is determined when the power supply system (2, 3) is activated for the first time and immediately after a repeat test of the power supply system (2, 3).

5. The method according to any one of claims 1 to 4,
**characterized in that**
the reference leakage current spectrum is determined by filtering the measured values.

6. An electrical protection device (50) for detecting a disconnection (20) of a protective conductor connection (8) with a subsystem (4) of a grounded power supply system (3), comprising a converter system connected to the subsystem (4), the electrical protection device (50) comprising
a device (52) for measuring a leakage current, a calculating unit (54) for calculating a leakage current spectrum and an evaluating process unit (56) for testing the calculated leakage current spectra and for signaling the disconnection (20) of the protective conductor connection (8)
**characterized in that**
the evaluating process unit (56) being configured so as to carry out the process steps according to claim 1.

7. The electrical protection device (50) according to claim 6,
**characterized in that**
the device (52) for measuring the leakage current, the calculating unit (54) for calculating the leakage current spectrum and the evaluating process unit (56) form an integrated combined device (51) as a structural unit on the basis of a device for determining network quality.

## Revendications

1. Procédé pour détecter une interruption (20) d'une connexion de conducteur de protection (8) à un sous-système (4) d'un système d'alimentation électrique (3) mis à la terre avec un système convertisseur connecté au sous-système (4), comprenant les étapes du procédé à effectuer pendant la mise en service du système convertisseur :
- mesurer un courant de fuite spécifique au système convertisseur pour différents points de fonctionnement de puissance du système convertisseur dans un état sans erreur du système d'alimentation mis à la terre (3),
- calculer un spectre de courant de fuite de référence spécifique au système convertisseur du courant de fuite,
et comprenant les étapes de procédé à exécuter de manière répétée pendant le fonctionnement du système convertisseur :
- mesurer un courant de fuite actuel pour chacun des différents points de fonctionnement de puissance du système convertisseur,
- calculer un spectre de courant de fuite actuel du courant de fuite respectif,
- vérifier si le spectre de courant de fuite calculé actuellement s'écarte du spectre de courant de fuite de référence correspondant,
- signaler qu'il y a une interruption (20) de la connexion de conducteur de protection (8) si le teste révèle qu'il y a l'écart du spectre de courant de fuite actuellement calculé par rapport au spectre de courant de fuite de référence correspondant.

2. Procédé selon la revendication 1,
**caractérisé en ce que**
calculer le spectre de courant de fuite de référence spécifique au système convertisseur et calculer le spectre de courant de fuite pendant le fonctionnement du système convertisseur comprennent le calcul de composantes spectrales de courant de fuite significatives, les composantes spectrales de courant de fuite significatives étant attribuées aux points de fonctionnement de puissance dans une phase d'apprentissage pendant une mise en service du système convertisseur.

3. Procédé selon la revendication 2,
**caractérisé en ce que**
les spectres de courant de fuite actuellement calculés sont testés dans chaque cas par comparaison aux emplacements des composantes spectrales significatives du courant de fuite.

4. Procédé selon l'une quelconque des revendications 1 à 3,
**caractérisé en ce que**
le spectre de courant de fuite de référence est déterminé lors de la première mise en service et immédiatement après un test de reprise du système d'alimentation électrique (2, 3).

5. Procédé selon l'une quelconque des revendications 1 à 4,
**caractérisé en ce que**
le spectre de courant de fuite de référence est déterminé par filtrage des valeurs mesurées.

6. Dispositif de protection électrique (50) pour détecter une interruption (20) d'une connexion de conducteur de protection (8) à un sous-système (4) d'un système d'alimentation électrique mis à la terre (3), comprenant un système inverseur connecté au sous-système (4), le dispositif de protection électrique comprenant un dispositif (52) pour mesurer un courant de fuite, une unité de calcul (54) pour calculer un spectre de courant de fuite et une unité de traitement d'évaluation (56) pour tester les spectres de courant de fuite calculés et pour signaler l'interruption (20) de la connexion de conducteur de protection (8),
**caractérisé en ce que**
l'unité de traitement d'évaluation (56) est configurée pour exécuter les étapes du procédé selon la revendication 1.

7. Dispositif de protection électrique (50) selon la revendication 6,
**caractérisé en ce que**
le dispositif (52) pour mesurer le courant de fuite, l'unité de calcul (54) pour calculer le spectre du courant de fuite et l'unité de traitement d'évaluation (56) forment un dispositif combiné intégré (51) comme unité structurelle sur la base d'un dispositif pour déterminer la qualité du réseau.
